(19) Europäisches Patentamt
European Patent Office
Office européen des brevets

(11) EP 4 289 882 A1

(12) # EUROPEAN PATENT APPLICATION
published in accordance with Art. 153(4) EPC

(43) Date of publication:
**13.12.2023 Bulletin 2023/50**

(21) Application number: **22749687.4**

(22) Date of filing: **01.02.2022**

(51) International Patent Classification (IPC):
***C08G 59/40*** *(2006.01)* ***C08K 5/5415*** *(2006.01)*
***C08L 63/00*** *(2006.01)* ***C08K 3/013*** *(2018.01)*

(52) Cooperative Patent Classification (CPC):
**C08G 59/40; C08K 3/013; C08K 5/5415; C08L 63/00**

(86) International application number:
**PCT/JP2022/003719**

(87) International publication number:
**WO 2022/168815 (11.08.2022 Gazette 2022/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.02.2021 JP 2021015288**

(71) Applicant: **ENEOS Corporation**
**Chiyoda-ku**
**Tokyo 100-8162 (JP)**

(72) Inventors:
- **SATO, Tatsuki**
  **Tokyo 100-8162 (JP)**
- **KOMATA, Ayumu**
  **Tokyo 100-8162 (JP)**

(74) Representative: **Müller-Boré & Partner Patentanwälte PartG mbB**
**Friedenheimer Brücke 21**
**80639 München (DE)**

(54) **COMPOSITION FOR CURABLE RESINS, CURED PRODUCT OF SAID COMPOSITION, METHOD FOR PRODUCING SAID COMPOSITION, METHOD FOR PRODUCING SAID CURED PRODUCT, AND SEMICONDUCTOR DEVICE**

(57) [Problem] To provide a curable resin composition having low weight reduction ratio during heat curing for obtaining a cured product having high heat resistance, but having reduced mold shrinkage ratio and coefficient of thermal expansion, a cured product thereof, and a method of producing the curable resin composition and the cured product. Also provided is a semiconductor device using the product as a sealant.

[Solution] A curable resin composition of the present invention includes: (A) a benzoxazine compound; (B) an epoxy compound; and (C) a phenolic curing agent, wherein the number of epoxy groups in the (B) epoxy compound, the number of benzoxazine rings in the (A) benzoxazine compound, and the number of hydroxyl groups in the (C) phenolic curing agent satisfy the mathematical formula (1), and the content of the (B) alicyclic epoxy compound is 3 to 12 mass% with respect to the total of the (A), (B), and (C).



Processed by Luminess, 75001 PARIS (FR)

## Description

CROSS-REFERENCE TO RELATED APPLICATIONS

This application is based upon and claims the benefit of priority from Japanese Patent Application No. 2021-15288, filed on February 2, 2021; the entire contents of which are incorporated herein by reference.

TECHNICAL FIELD

The present invention relates to a curable resin composition for obtaining a cured product having high heat resistance, a cured product thereof, and methods of producing the curable resin composition and the cured product. Furthermore, the present invention relates to a semiconductor device using the cured product as a sealant.

BACKGROUND ART

Curable resins are used in various applications for semiconductor sealants, fiber reinforced plastics, and the like, and benzoxazine compounds are used as one of the raw materials of such resins. Benzoxazine compounds refer to compounds each having a benzoxazine ring containing a benzene backbone and an oxazine backbone, and benzoxazine resins as cured products (polymerized products) thereof are excellent in physical properties such as heat resistance and mechanical strength, and are used as high-performance materials in various applications.

Furthermore, there is a need to improve imperfect molding, for example, to reduce a mold shrinkage ratio when the curable resin is used as a semiconductor sealant or the like. Here, a weight reduction ratio and a coefficient of thermal expansion during heat curing are known to affect the mold shrinkage ratio. The weight reduction ratio during heat curing is considered to reflect volatilization of low molecular weight components, and it is possible to improve the working environment and to stabilize the composition of the resin composition by reducing the weight reduction ratio.

Patent Literature 1 describes that a highly reliable cured product that has low coefficient of thermal expansion after curing can be obtained from an adhesive for electronic components characterized by containing an aliphatic epoxy compound and a benzoxazine compound as a base curing agent, and a phenolic curing agent.

Patent Literature 2 describes that an epoxy resin composition, not using a benzoxazine compound, but containing an epoxy resin selected from trifunctional epoxy resins and tetrafunctional epoxy resins, a curing agent having two hydroxyl groups in a single molecule, a compound having two cyanate groups in a single molecule, and an inorganic filler, is excellent in flame retardance, solder cracking resistance, and fluidity, and can provide a semiconductor device with less warpage after molding or during soldering process or at low temperature such as during a temperature cycling test.

RELATED ART DOCUMENTS

Patent Literature

[Patent Literature 1] JP-A 2013-008800
[Patent Literature 2] WO 2007/037500

SUMMARY OF THE INVENTION

Problems to be Solved by the Invention

However, the present inventors have found that Patent Literature 1 and 2 have the following technical problems. The adhesive for electronic components described in Patent Literature 1 has a problem that a cured product having a high glass transition temperature cannot be obtained. The epoxy resin composition described in Patent Literature 2 has a problem that there is a limit to the thermal expansion coefficient reduction.

The present inventors have made intensive studies in order to solve the above problems, and as a result, have developed a curable resin composition containing a benzoxazine compound, an epoxy compound, and a phenolic curing agent at a specific ratio, and have found that the weight reduction ratio of the curable resin composition during heat curing is low, a cured product thereof is excellent in heat resistance, and mold shrinkage ratio and coefficient of thermal expansion of the cured product are reduced.

Accordingly, an object of the present invention is to provide a curable resin composition having a low weight

reduction ratio during heat curing, for obtaining a cured product having high heat resistance, but having low mold shrinkage ratio and low coefficient of thermal expansion. Another object of the present invention is to provide a cured product obtained by curing the curable resin composition, and method of producing the curable resin composition and the cured product. Another object of the present invention is to provide a semiconductor device using the cured product as a sealant.

Means for Solving the Problems

That is, the present invention provides the following inventions.

[1] A curable resin composition including:

(A) a benzoxazine compound;
(B) an epoxy compound; and
(C) a phenolic curing agent,

wherein the number of benzoxazine rings in the (A) benzoxazine compound, the number of epoxy groups in the (B) epoxy compound, and the number of hydroxyl groups in the (C) phenolic curing agent satisfy the following mathematical formula (1),
the (B) epoxy compound comprises an alicyclic epoxy compound, and
the content of the (B) alicyclic epoxy compound is 3 to 12% by mass with respect to the total of the (A) benzoxazine compound, the (B) epoxy compound, and the (C) phenolic curing agent:
[Math. 1]

$$\text{(number of benzoxazine rings + number of hydroxyl groups)/number of epoxy groups} = 0.8 \text{ to } 5 \quad (1)$$

[2] The curable resin composition according to [1], wherein the (A) benzoxazine compound is a multifunctional benzoxazine compound having at least two benzoxazine rings, the compound being at least one multifunctional benzoxazine compound selected from a multifunctional benzoxazine compound having a structural unit of formula (1) and a multifunctional benzoxazine compound represented by a structure of formula (2);

[Chem. 1]

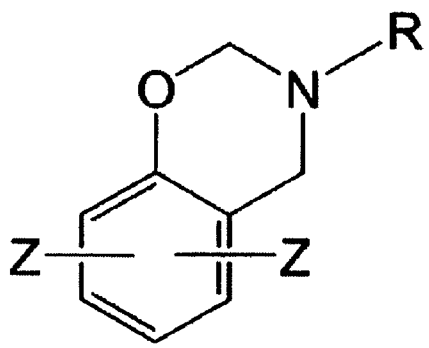
(1)

wherein in the formula (1), R represents a linear alkyl group having 1 to 12 carbon atoms, a cyclic alkyl group having 3 to 8 carbon atoms, or an aryl group having 6 to 14 carbon atoms, wherein the aryl group optionally has halogen or a linear alkyl group having 1 to 12 carbon atoms, as a su bstituent;
and each Z represents hydrogen, a hydrocarbon group having 1 to 8 carbon atoms and/or a linking group and is optionally the same or different; at least one Z represents a linking group, and the benzoxazine rings are linked by the linking group;

[Chem. 2]

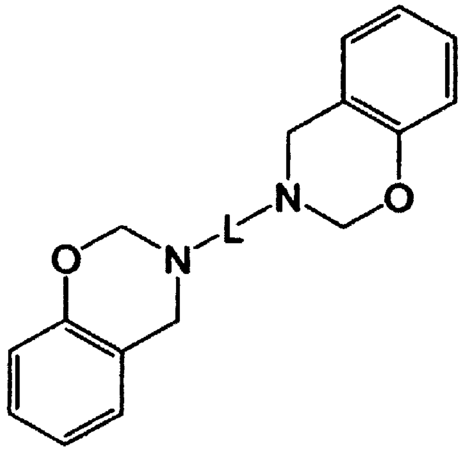

(2)

wherein in the formula (2), L represents a divalent organic group having 1 to 5 aromatic rings or an alkylene group having 2 to 10 carbon atoms, and the organic group and the alkylene group optionally contain oxygen and/or sulfur.

[3] The curable resin composition according to [1] or [2], wherein the alicyclic epoxy compound is an epoxy compound having at least one norbornane structure, and at least two epoxy groups.
[4] The curable resin composition according to any one of [1] to [3], wherein the alicyclic epoxy compound has at least one structure selected from the group consisting of a 5-membered ring structure, 6-membered ring structure, and a norbornane ring structure represented by the formula (3);

[Chem. 3]

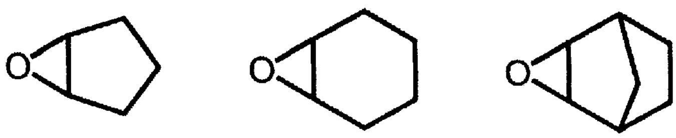

(3)

[5] The curable resin composition according to any one of [1] to [4], wherein the alicyclic epoxy compound has no glycidyl group.
[6] The curable resin composition according to any one of [1] to [5], further containing (D) a silane coupling agent.
[7] The curable resin composition according to [6], wherein the (D) silane coupling agent contains at least one primary amino group and at least one secondary amino group in a single molecule.
[8] The curable resin composition according to any one of [1] to [7], further containing (E) a curing accelerator.
[9] The curable resin composition according to any one of [1] to [8], further containing (F) an inorganic filler.
[10] The curable resin composition according to [9], wherein the content of the (F) inorganic filler is 80 to 95% by mass with respect to the total of the curable resin composition.
[11] A cured product obtained by curing the curable resin composition according to any one of [1] to [10].
[12] A semiconductor device, wherein a semiconductor element is disposed in a cured product obtained by curing the curable resin composition according to any one of [1] to [10].
[13] A method of producing the curable resin composition according to any one of [1] to [10], the method including the steps of:

mixing

(A) a benzoxazine compound,
(B) an epoxy compound, and
(C) a phenolic curing agent

to obtain a mixture; and
processing the mixture into a powdery, pelletized, or granular curable resin composition.

[14] The production method according to [13], wherein the step of obtaining the mixture includes further mixing at least one component selected from the group consisting of (D) a silane coupling agent, (E) a curing accelerator, and (F) an inorganic filler.

[15] A method of producing a cured product, comprising a step of heating the curable resin composition produced by the method according to [13] or [14], at 150 to 300°C for 20 seconds to 6 hours for curing.

Effects of the Invention

The curable resin composition of the present invention is a novel curable resin composition containing components (A) to (C) at a specific ratio, and further, if desired, components (D), (E), and (F), and is characterized in that the composition has low weight reduction ratio during heat curing, and that a cured product of the composition has high heat resistance and excellent in mold shrinkage ratio and coefficient of thermal expansion. Furthermore, the above-described curable resin composition is also characterized by having low melt viscosity. Accordingly, the curable resin composition of the present invention can be used in applications in which improvement of imperfect molding and, if desired, low melt viscosity is demanded, and still heat resistance is needed, for example, applications of adhesives, sealants, paints, and matrix resins for composite materials. In particular, the composition can be suitably used as a sealant such as a WLP sealant or a PLP sealant.

MODE FOR CARRYING OUT THE INVENTION

[Curable Resin Composition]

Hereinafter, the present invention will be described in detail. It is noted that each "compound", "curing agent", or "silane coupling agent" in components (A) to (D) in the present invention encompasses not only a monomer, but also an oligomer obtained by polymerization of the monomer, for example, an oligomer obtained by polymerization of a small amount of the monomer, namely, a prepolymer before the formation of a curable resin. Accordingly, the curable resin composition of the present invention may be a curing resin composition.

(Component (A))

Component (A) that constitutes the curable resin composition is a benzoxazine compound, preferably at least one multifunctional benzoxazine compound having at least two benzoxazine rings, selected from a multifunctional benzoxazine compound having a structural unit of formula (1) and a multifunctional benzoxazine compound represented by a structure of formula (2). Herein, in the above described formula (1), each Z represents hydrogen, a substituent and/or a linking group (spacer) and is optionally the same or different, at least one Z represents a linking group, and the benzoxazine rings are linked by the linking group. The linking group as used here encompasses two benzoxazine rings directly bound via no other group. Examples of the substituent include a hydrocarbon group having 1 to 8 carbon atoms.

Accordingly, the formula (1) represents the structural unit of any compound wherein two or more benzoxazine rings are linked at a benzene ring moiety, among options of component (A).

The multifunctional benzoxazine compound of formula (1) can be more specifically represented as having a structure represented by formula (1a):

[Chem. 4]

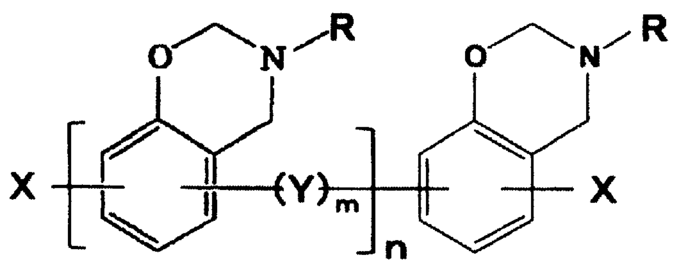

(1a)

wherein in the formula (1a), R represents a linear alkyl group having 1 to 12 carbon atoms, a cyclic alkyl group having 3 to 8 carbon atoms, or an aryl group having 6 to 14 carbon atoms, wherein the aryl group optionally has halogen or a linear alkyl group having 1 to 12 carbon atoms, as a substituent; each R is optionally the same or different; each X represents hydrogen or a hydrocarbon group having 1 to 8 carbon atoms, and is optionally the same or different; Y

represents an alkylene group having 1 to 6 carbon atoms, oxygen, sulfur, a $SO_2$ group, or a carbonyl group; m is 0 or 1; and n is an integer of 1 to 10.

Specific examples of R in formulae (1) and (1a) can include the following groups.

Examples of the linear alkyl group having 1 to 12 carbon atoms include a methyl group, an ethyl group, a propyl group, an isopropyl group, an n-butyl group, an isobutyl group, and a t-butyl group.

Examples of the cyclic alkyl group having 3 to 8 carbon atoms include a cyclopentyl group and a cyclohexyl group.

Examples of the aryl group having 6 to 14 carbon atoms include a phenyl group, a 1-naphthyl group, a 2-naphthyl group, a phenanthryl group, and a biphenyl group.

The aryl group having 6 to 14 carbon atoms is optionally substituted, and examples of the substituent include a linear alkyl group having 1 to 12 carbon atoms, and halogen. Examples of the aryl group having 6 to 14 carbon atoms, substituted with a linear alkyl group having 1 to 12 carbon atoms or halogen, include an o-tolyl group, a m-tolyl group, a p-tolyl group, a xylyl group, an o-ethylphenyl group, a m-ethylphenyl group, a p-ethylphenyl group, an o-t-butylphenyl group, a m-t-butylphenyl group, a p-t-butylphenyl group, an o-chlorophenyl group, and an o-bromophenyl group.

R is preferably selected from a methyl group, an ethyl group, a propyl group, a phenyl group and a p-tolyl group, from the viewpoint of favorable handleability.

Component (A) may also be a mixture of a plurality of kinds of compounds represented in one of formulae (1) and (1a), which are different in R from each other.

Examples of the hydrocarbon group having 1 to 8 carbon atoms as X in formulae (1) and (1a) include an alkyl group, an aryl group, and an aralkyl group, and an aryl group is preferable.

Examples of the multifunctional benzoxazine compound represented by formula (1) or (1a) can include a compound represented by the following formula (1X), and an oligomer obtained by polymerization of small amounts of the compound.

[Chem. 5]

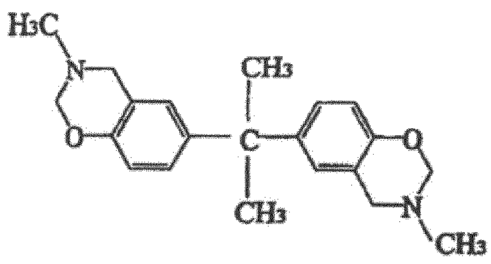

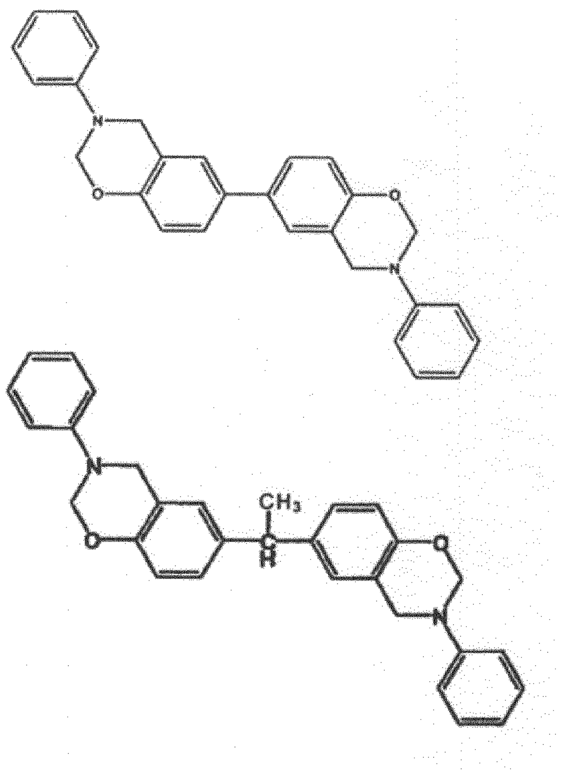

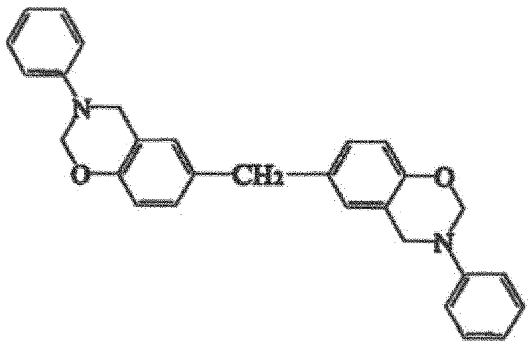

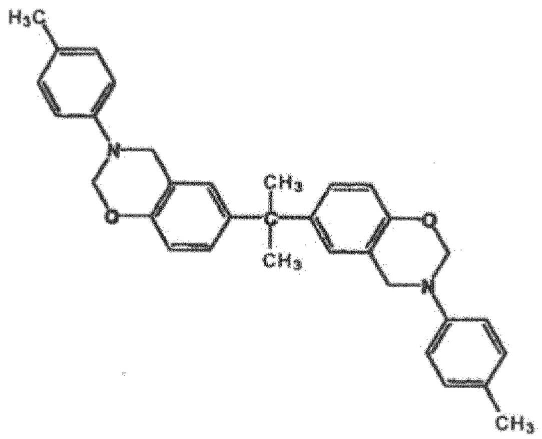

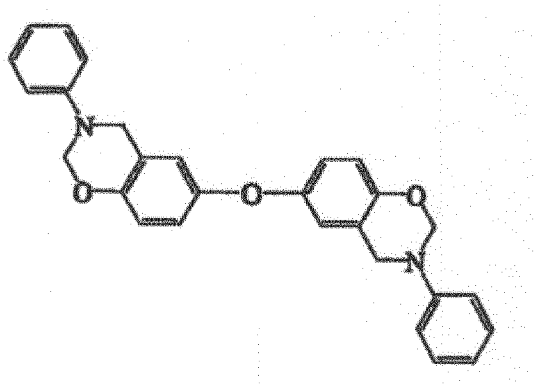

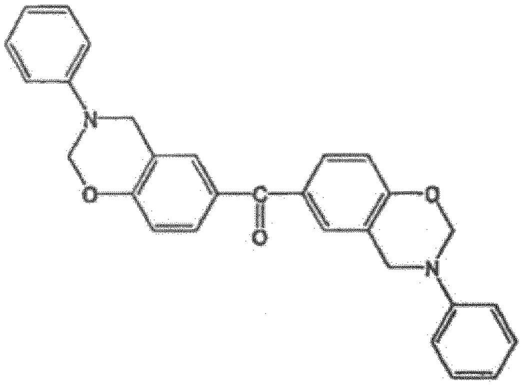

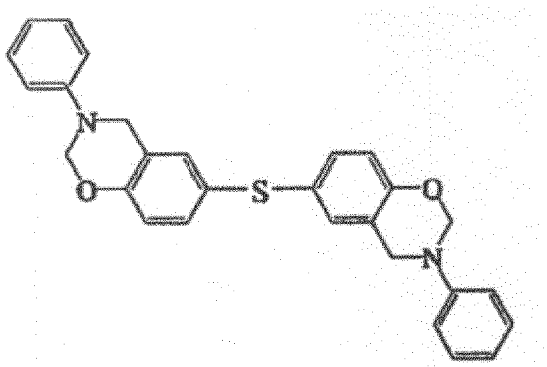

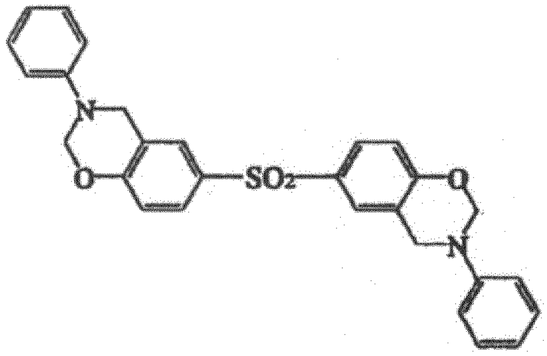

(1X)

The multifunctional benzoxazine compound of formula (2), as another option of component (A), is a compound wherein the respective nitrogen atoms (N atoms) in two benzoxazine rings are bound via a linking group L,

[Chem. 6]

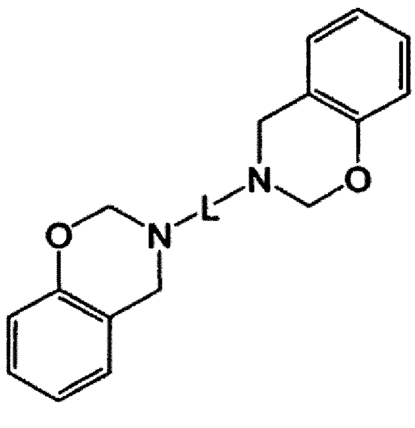

(2)

wherein in the formula (2), L represents a divalent organic group having 1 to 5 aromatic rings or an alkylene group having 2 to 10 carbon atoms, and the organic group and the alkylene group optionally contain oxygen and/or sulfur.

The composition of the present invention may contain, as component (A), a plurality of kinds of multifunctional benzoxazine compounds represented by formula (2), which are different in L.

In cases where L in formula (2) represents an aromatic ring-containing group, the group contains 1 to 5 aromatic rings, and examples thereof include a monocyclic compound, a multicyclic compound, and a fused ring compound. L may also contain at least one selected from the group consisting of oxygen and sulfur.

Specific examples can include a group represented by the following formula (2a).

[Chem. 7]

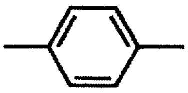
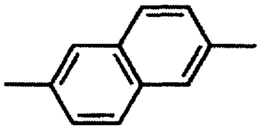
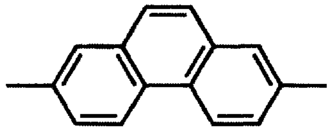
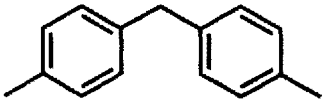
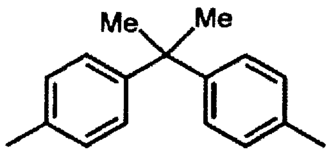
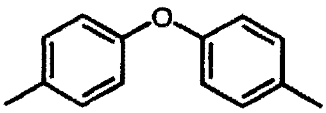
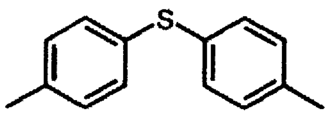
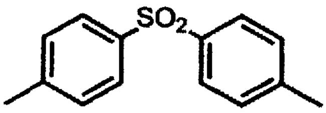
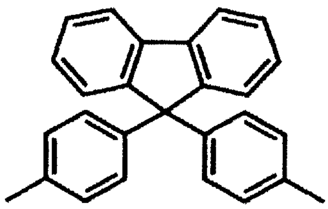
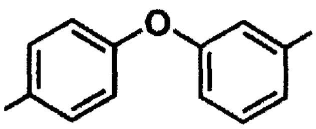

(2 a)

In cases where L in formula (2) represents an alkylene group, the alkylene group has, for example, 1 to 10 carbon atoms, preferably 1 to 6 carbon atoms. Specific examples of the alkylene group include a methylene group, an ethylene group, and an isopropylidene group, and preferably include a methylene group.

Examples of the multifunctional benzoxazine compound of formula (2) can include a compound represented by the following formula (2X), and an oligomer obtained by polymerization of the compound, for example, an oligomer obtained by polymerization of a small amount of the compound.

[Chem. 8]

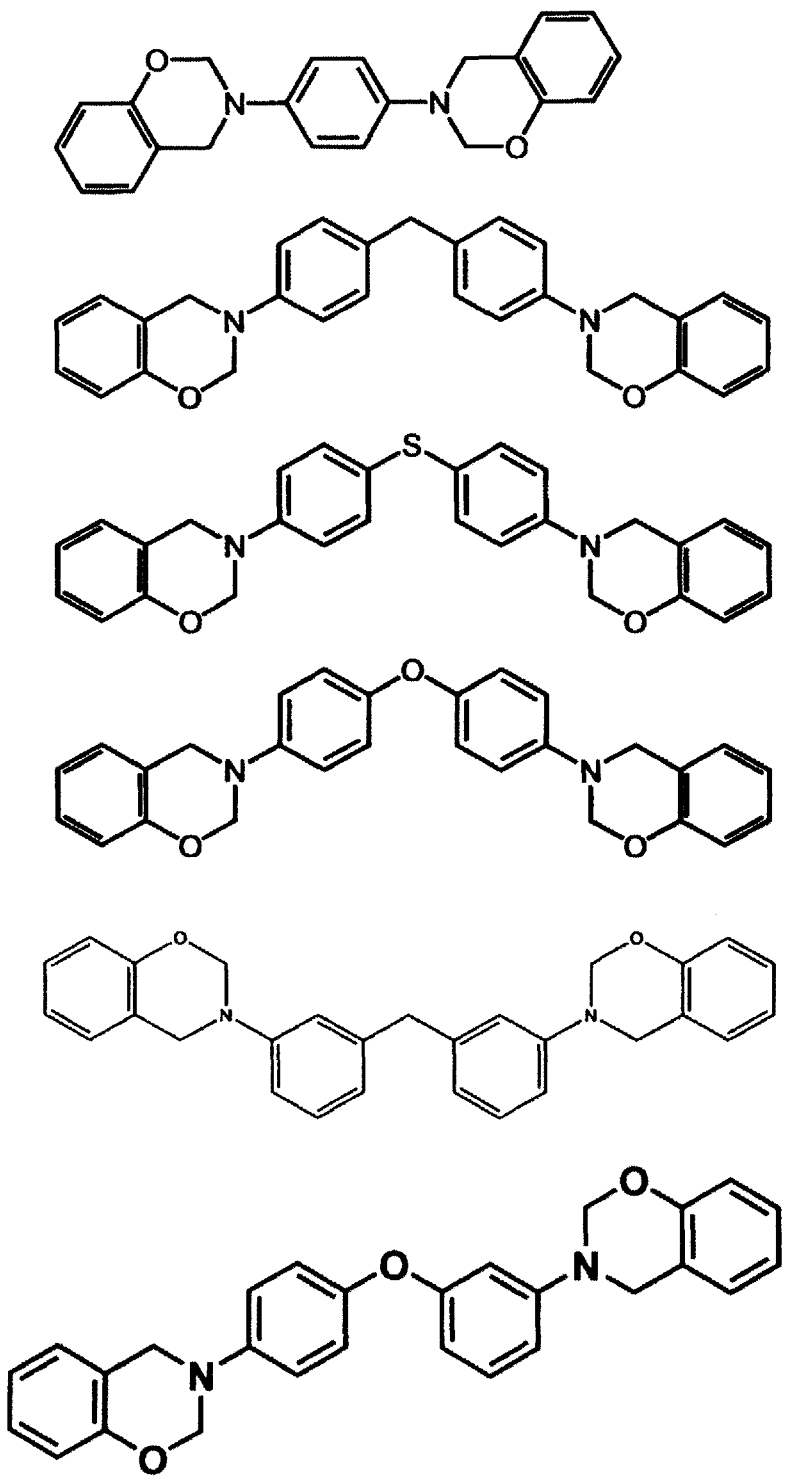

(2 X)

Examples of the multifunctional benzoxazine compound of component (A) preferably include bisphenol F-aniline (F-a)-type benzoxazine, phenol-diaminodiphenylmethane (P-d)-type benzoxazine, (3-[4-[4-(2,4-dihydro-1,3-benzoxazin-3-yl) phenoxy]phenyl]-2,4-dihydro-1,3-benzoxazine), and (3-[3-[4-(2H-1,3-benzoxazin-3(4H)-yl) phenoxy] phenyl]-3,4-dihydro-2H-1,3-benzoxazine) (hereinafter also referred to as 3,4'-APE-BOZ), and more preferably phenol-diaminodiphenylmethane (P-d)-type benzoxazine and 3,4'-APE-BOZ. Here, 3,4'-APE-BOZ can be produced based on the description of Synthesis Example 1 in JP-A 2018-184533.

Any commercially available product can also be used as the multifunctional benzoxazine compound in component (A). Examples of such a commercially available product can include bisphenol F-aniline (F-a)-type benzoxazine and phenol-diaminodiphenylmethane (P-d)-type benzoxazine (both are manufactured by SHIKOKU CHEMICALS CORPORATION).

Benzoxazine equivalent of component (A) of the benzoxazine compound is preferably 135 g/eq or more and 600 g/eq or less, and more preferably 140 g/eq or more and 400 g/eq or less, from the viewpoint of improving reactivity. Here, the benzoxazine equivalent of component (A) the benzoxazine compound refers to an equivalent assuming that the benzoxazine ring in component (A) benzoxazine compound is monofunctional.

The number of benzoxazine rings (mol) in component (A) the benzoxazine compound is calculated from the benzoxazine equivalent of component (A) the benzoxazine compound. In cases where the composition of the present invention contains a plurality of kinds of the benzoxazine compounds as component (A), the number of the benzoxazine rings is assumed to be the total of the number of rings calculated from the benzoxazine equivalent of such compounds.

(Component (B))

Component (B) that constitutes the curable resin composition is an epoxy compound. Such epoxy compound is not particularly limited as long as it does not depart from the gist of the present invention, and examples thereof include alicyclic epoxy compounds, biphenyl type epoxy compounds, trisphenolmethane type epoxy compounds, naphthalene type epoxy compounds, novolac type epoxy compounds, phenolaralkyl type epoxy compounds, and epoxy compounds containing cyclohexene oxide groups, preferably alicyclic epoxy compounds, trisphenolmethane type epoxy compounds, naphthalene type epoxy compounds.

In a preferred embodiment of the present invention, the curable resin composition contains a mixture of a plurality of kinds of epoxy compounds as component (B). The mixture of the epoxy compounds preferably contains an alicyclic epoxy compound. Examples of the mixture of the epoxy compounds include a combination of an alicyclic epoxy compound and an epoxy compound other than the alicyclic epoxy compound. Examples of the epoxy compound other than the alicyclic epoxy compound preferably include at least one epoxy compound selected from biphenyl type epoxy compound, trisphenolmethane type epoxy compound, naphthalene type epoxy compound, novolac type epoxy compound, phenolaralkyl type epoxy compound, and an epoxy compound having a cyclohexene oxide group, more preferably, trisphenolmethane type epoxy compound, naphthalene type epoxy compound or a combination thereof.

Epoxy equivalent of component (B) the epoxy compound is preferably 50 g/eq or more and 400 g/eq or less, more preferably 80 g/eq or more and 300 g/eq or less, from the viewpoint of improving reactivity.

The number of epoxy groups (mol) in component (B) of the epoxy compound is calculated from the epoxy equivalent. In cases where the composition of the present invention contains a plurality of kinds of epoxy compounds as component (B), the number of epoxy groups is assumed to be the total number of epoxy groups in such compounds.

(Alicyclic epoxy compound)

The alicyclic epoxy compound is not particularly limited as long as it does not depart from the gist of the present invention, and examples thereof include an epoxy compound having one or more alicyclic hydrocarbon structures and one or more epoxy groups in its molecule, preferably an epoxy compound having at least one alicyclic hydrocarbon structure and at least two epoxy groups, and more preferably an epoxy compound having at least one norbornane structure and at least two epoxy groups. Moreover, the alicyclic epoxy compound preferably has no glycidyl group.

(Epoxy compound having at least one norbornane structure and at least two epoxy groups)

The epoxy compound having at least one norbornane structure and at least two epoxy groups preferably has an epoxy structure bound to a 5-membered ring, a 6-membered ring, or a norbornane ring, represented by the following formula (4). These may be used singly or in combination of two or more kinds thereof.

[Chem. 9]

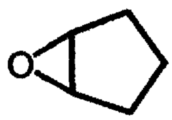 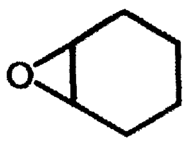 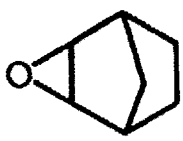 (4)

In the preferred embodiment of the present invention, the epoxy compound having at least one norbornane structure and at least two epoxy groups has no glycidyl group.

Specific examples of the alicyclic epoxy compound can include a compound represented by the following formula (5).

[Chem. 10]

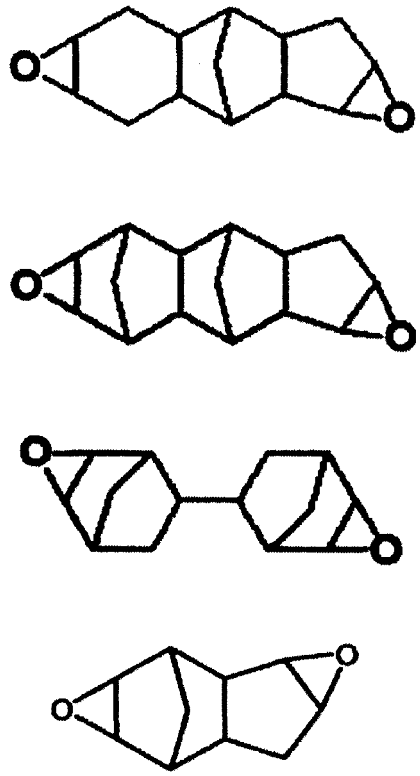

(5)

A production example of the alicyclic epoxy compound in component (B) will be described.

A compound of the following formula (5-1) (epoxy equivalent: 109 g/eq) can be produced by, for example, synthesizing a compound (a) having the following norbornane structure, by a Diels-Alder reaction of butadiene and dicyclopentadiene, and then reacting the compound (a) and meta-chloroperbenzoic acid, as represented in the following formula (6).

[Chem. 11]

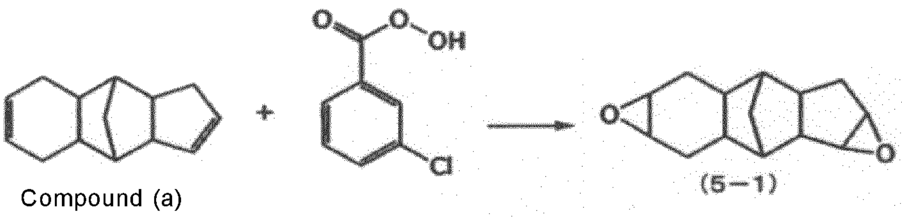

Compound (a)

(5-1)

(6)

A compound of the following formula (5-2) (epoxy equivalent: 115 g/eq) can be produced by, for example, synthesizing a compound (b) (tricyclopentadiene) having the following norbornane structure, by a Diels-Alder reaction of cyclopentadiene and dicyclopentadiene, and then reacting the compound (b) and meta-chloroperbenzoic acid, as represented in the following formula (7).

[Chem. 12]

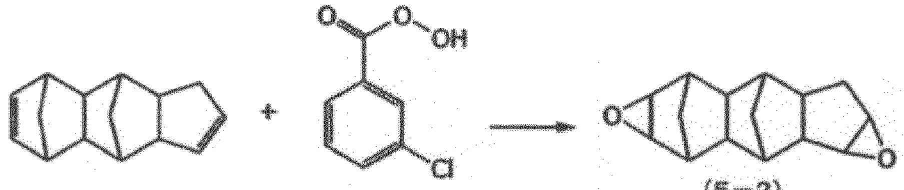

Compound (b)

(5−2)

(7)

A compound of the following formula (5-3) (epoxy equivalent: 109 g/eq) can be produced by, for example, synthesizing a compound (c) having the following norbornane structure, by a Diels-Alder reaction of butadiene and cyclopentadiene, and then reacting the compound (c) and meta-chloroperbenzoic acid, as represented in the following formula (8).

[Chem. 13]

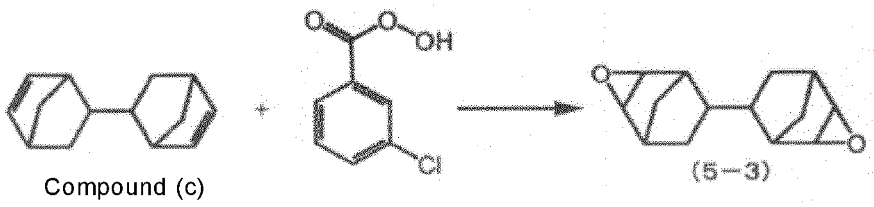

Compound (c)

(5−3)

(8)

A compound of the following formula (5-4) (epoxy equivalent: 82.1 g/eq) can be produced by, for example, reacting dicyclopentadiene and potassium peroxymonosulfate (oxone). The compound of formula (5-4), dicyclopentadiene diepoxide, may also be any commercially available product, and examples of such a commercially available product can include dicyclopentadiene diepoxide manufactured by SHANDONG QIHUAN BIOCHEMICAL CO., LTD.

[Chem. 14]

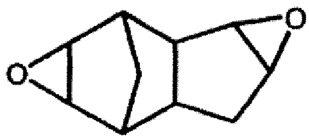

(5−4)

(Trisphenolmethane type epoxy compound)

The trisphenolmethane type epoxy compound is not particularly limited as long as the compound does not depart from the gist of the present invention. Such a compound is preferably an epoxy compound represented by a structure of the following formula (9).

[Chem. 15]

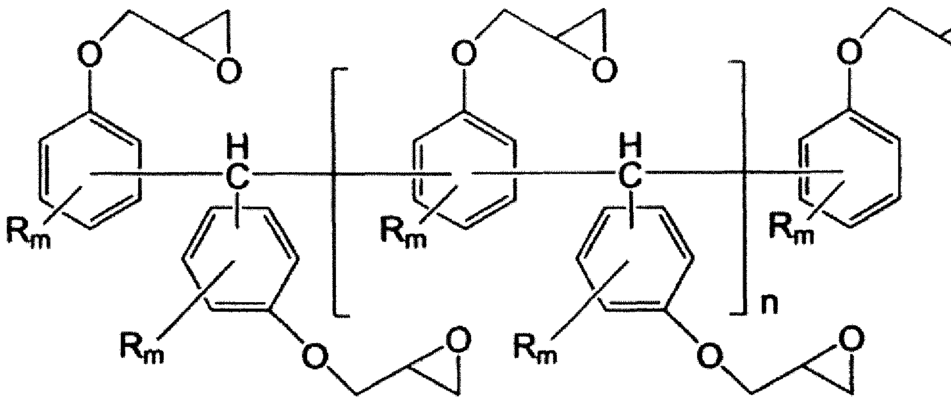

(9)

wherein in the formula (9), R is a substituent and independently represents an alkyl group having 1 to 6 carbon atoms, an allyl group or a phenyl group; m represents the number of the substituent(s) R and is an integer of 0 to 3; and n represents an average value, satisfying $0 \leq n \leq 10$.

In formula (9), m is preferably 0 to 2, more preferably 0. In formula (9), n is preferably 0 or more and 5 or less. Examples of the alkyl group having 1 to 6 carbon atoms in the substituent R of formula (9) include a methyl group, an ethyl group, a propyl group, a butyl group, a cyclohexyl group, and the like. The substituent R is preferably a methyl group. Furthermore, the trisphenolmethane type epoxy compound may be a mixture of compounds represented by formula (9), wherein the compounds are different from each other in R, m, or n in the formula.

Any commercially available product can also be used as the trisphenolmethane type epoxy compound. Examples of such a commercially available product include EPPN-501H (a tradename; manufactured by NIPPON KAYAKU CO., LTD.; epoxy equivalent 162 to 172 g/eq; softening point, 51 to 57°C), EPPN-501HY (a tradename; manufactured by NIPPON KAYAKU CO., LTD.; epoxy equivalent 163 to 175 g/eq; softening point, 57 to 63°C), EPPN-502H (a tradename; manufactured by NIPPON KAYAKU CO., LTD.; epoxy equivalent 158 to 178 g/eq; softening point, 60 to 72°C), EPPN-503 (a tradename; manufactured by NIPPON KAYAKU CO., LTD.; epoxy equivalent 170 to 190 g/eq; softening point, 80 to 100°C), and the like. These may be used singly or in combination of two or more kinds thereof.

(Naphthalene type epoxy compound)

The naphthalene type epoxy compound is not particularly limited as long as the compound does not depart from the gist of the present invention. Such a compound is, for example, a naphthol type epoxy compound, a naphthyleneether type epoxy compound, a binaphthalene type epoxy compound, or the like, preferably a naphthol type epoxy compound, or the like.

(Naphthol type epoxy compound)

The naphthol type epoxy compound is not particularly limited as long as the compound does not depart from the gist of the present invention. Such a compound is preferably an epoxy compound represented by a structure of the following formula (10).

[Chem. 16]

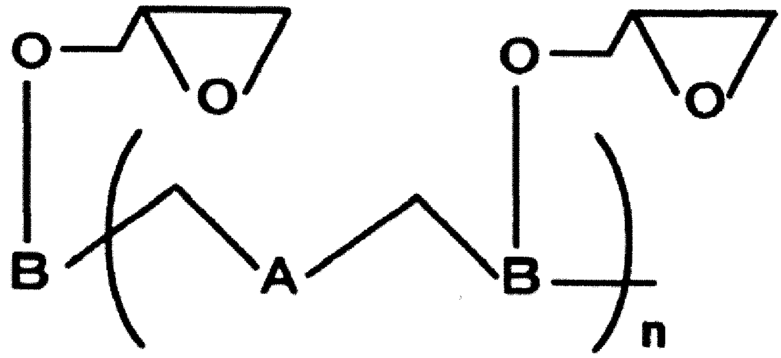

(1 0)

wherein in the formula (10), A and B independently represent substituted or unsubstituted benzene, or substituted or unsubstituted naphthalene; and n represents repeating units, and is an integer of 1 or more and 10 or less.

The unsubstituted benzene or naphthalene consists only of benzene or naphthalene, whereas the substituted benzene or naphthalene includes a benzene or naphthalene ring in which an aromatic hydrocarbon group thereof has a substituent. The aromatic hydrocarbon group having a substituent means that some or all of hydrogen atoms constituting the aromatic hydrocarbon group are substituted with the substituent(s). Examples of the substituent include organic groups including glycidyl ether groups, and alkyl groups.

The alkyl group as the substituent is preferably a linear alkyl group. In addition, the number of carbon atoms of the alkyl group is preferably 1 or more and 10 or less, more preferably 1 or more and 6 or less, and particularly preferably 1 or more and 4 or less. Specific examples include a methyl group, an ethyl group, a propyl group, an isopropyl group, a butyl group, a tert-butyl group, a sec-butyl group, and the like.

Preferred specific examples of the naphthol type epoxy compound represented by the formula (10) include naphthol type epoxy compounds represented by the following formulae (10-1) to (10-4). These may be used singly or in combination of two or more kinds thereof.

[Chem. 17]

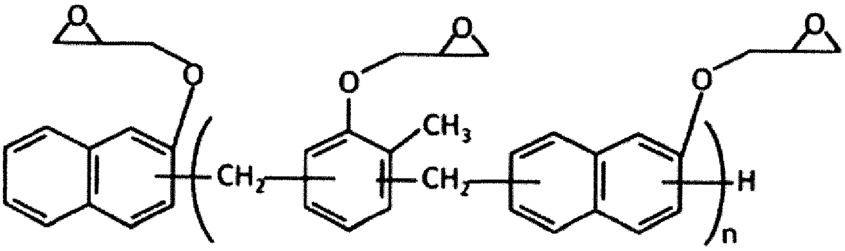

(1 0 − 1)

[Chem. 18]

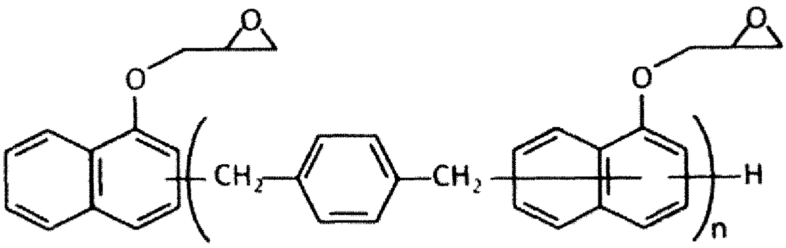

(1 0 − 2)

[Chem. 19]

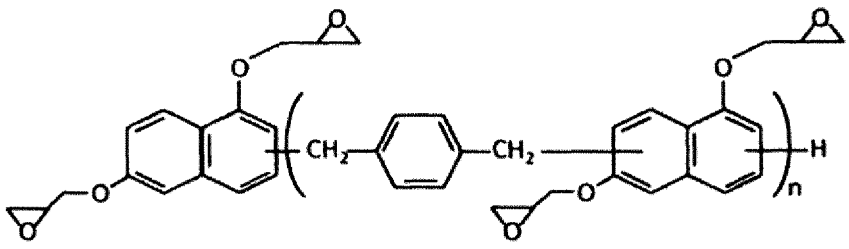

(1 0 - 3)

[Chem. 20]

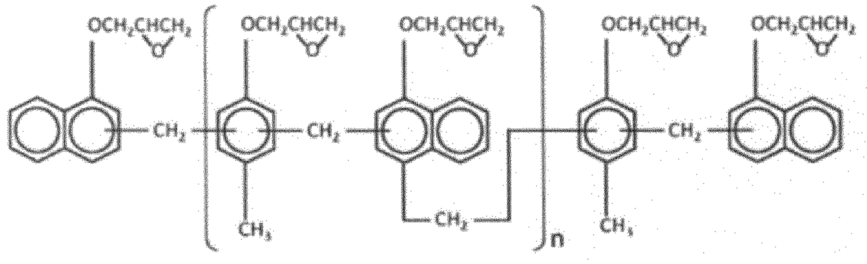

(1 0 - 4)

wherein in the formulae (10-1) to (10-4), n is an integer of, for example, 0 or more and 10 or less, preferably an integer of 0 or more and 6 or less, more preferably an integer of 0 or more and 4 or less, and still more preferably an integer of 0 or more and 3 or less.

Any commercially available product can also be used as the naphthol type epoxy compound. For example, NC-7000L (a tradename; manufactured by NIPPON KAYAKU CO., LTD., epoxy equivalent 223 to 238 g/eq), NC-7300L (a tradename; manufactured by NIPPON KAYAKU CO., LTD., epoxy equivalent 207 to 221 g/eq), ESN-475V (a tradename; manufactured by NIPPON STEEL & SUMIKIN CHEMICAL CO., LTD; epoxy equivalent 332 g/eq), ESN-375 (a tradename; manufactured by NIPPON STEEL & SUMIKIN CHEMICAL CO., LTD; epoxy equivalent 170 g/eq) and the like can be used as such a commercially available product of the naphthol type epoxy compound. These may be used singly or in combination of two or more kinds thereof.

The compounding ratio between component (A) the benzoxazine compound and component (B) the epoxy compound is preferably 10 to 300 parts by mass, more preferably 30 to 200 parts by mass, in terms of the compounding ratio of component (B) with respect to 100 parts by mass of component (A). When the compounding ratio between component (A) and component (B) is in the above range, it is possible to obtain more excellent heat resistance.

In cases where the composition of the present invention contains a plurality of kinds of benzoxazine compounds as component (A), the total compounding amount of such compounds is assumed to be 100 parts by mass. In cases where the composition of the present invention contains a plurality of kinds of epoxy compounds as component (B), the compounding amount of component (B) means the total compounding amount of such a plurality of kinds of compounds.

The content of component (B) the alicyclic epoxy compound is preferably 3 to 12 parts by mass (i.e., 3 to 12% by mass), more preferably 3 to 10 parts by mass (i.e., 3 to 10% by mass), still more preferably 4 to 10 parts by mass (i.e., 4 to 10% by mass) with respect to 100 parts by mass in total of component (A) the benzoxazine compound, component (B) the epoxy compound, and component (C) the phenolic curing agent. When the compounding ratio of component (B) the alicyclic epoxy compound is in the above range, it is possible to obtain more excellent heat resistance or more excellent weight reduction ratio.

In cases where the composition of the present invention contains a plurality of kinds of benzoxazine compounds as component (A), the compounding amount of component (A) means the total compounding amount of such a plurality of kinds of compounds. Cases where the composition of the present invention contains a plurality of kinds of epoxy compounds as component (B) are as described above. In cases where the composition of the present invention contains a plurality of kinds of alicyclic epoxy compounds as component (B), the content of the alicyclic epoxy compound of component (B) means the total content of such a plurality of kinds of alicyclic epoxy compounds.

The content of the alicyclic epoxy compound in component (B) the epoxy compound is preferably 5 to 45 parts by mass, more preferably 10 to 40 parts by mass, still more preferably 15 to 35 parts by mass, with respect to 100 parts by mass of component (B) the epoxy compound. When the compounding ratio of component (B) is in the above range, it is possible to exhibit more excellent low melt viscosity and more excellent weight reduction ratio.

In cases where the composition of the present invention contains a plurality of kinds of benzoxazine compounds as component (A) and/or a plurality of kinds of alicyclic epoxy compounds or epoxy compounds as component (B), the compounding amount thereof is as described above.

(Component C)

Component (C) that constitutes the curable resin composition is a phenolic curing agent. Component (C) is not particularly limited as long as it does not depart from the gist of the present invention. Such a component is, for example, monofunctional phenol, multifunctional phenol compounds (for example, bisphenol A, bisphenol F, dihydroxynaphthalene, bisphenol sulfide (for example, bis(4-hydroxyphenyl)sulfide and the like), polyphenol compounds (for example, pyrogallol and the like) and the like), phenol novolac resin, phenol aralkyl resin (for example, phenolaralkyl resin having a biphenylene backbone, phenolaralkyl resin having a phenylene backbone) and the like, preferably bisphenol F, phenol novolac resin. These may be used singly or in a mixture of two or more kinds thereof.

Any commercially available product can also be used as the phenolic curing agent of component (C). Examples thereof include bisphenol F (manufactured by HONSHU CHEMICAL INDUSTRY CO., LTD.; hydroxyl equivalent 100 g/eq), bis(4-hydroxyphenyl)sulfide (TDP, manufactured by TOKYO CHEMICAL INDUSTRY CO., LTD.; hydroxyl equivalent, 109 g/eq), 2,7-dihydroxynaphthalene (manufactured by TOKYO CHEMICAL INDUSTRY CO., LTD.; hydroxyl equivalent, 80 g/eq), pyrogallol (manufactured by TOKYO CHEMICAL INDUSTRY CO., LTD.; hydroxyl equivalent 42 g/eq), phenol novolac resin (for example, Phenolite TD-2131, DIC CORPORATION, hydroxyl equivalent 104 g/eq; Phenolite TD-2106, DIC CORPORATION, hydroxyl equivalent 104 g/eq; Phenolite TD-2090, DIC CORPORATION, hydroxyl equivalent 105 g/eq), phenol aralkyl resin (for example, MEHC-7851SS, hydroxyl equivalent 203 g/eq, manufactured by MEIWA PLASTIC INDUSTRIES, LTD.; MEH-7800-4S, hydroxyl equivalent 169 g/eq, manufactured by MEIWA PLASTIC INDUSTRIES, LTD.). These may be used singly or in combination of two or more kinds thereof.

The compounding ratio of component (C) is preferably in the range of 5 to 30 parts by mass, more preferably in the range of 10 to 20 parts by mass, in terms of the compounding ratio of component (C) with respect to 100 parts by mass of the total of components (A) and (B). When component (C) is contained in such a range, it is possible to provide a cured product having more excellent high heat resistance. In cases where the composition of the present invention contains a plurality of kinds of the benzoxazine compounds as component (A) and/or a plurality of kinds of epoxy compounds as component (B), the compounding amount of such compounds is as described above.

Hydroxyl equivalent of component (C) the phenolic curing agent is preferably 80 g/eq or more and 400 g/eq or less, more preferably 90 g/eq or more and 250 g/eq or less, from the viewpoint of improving reactivity.

The number of hydroxyl groups (mol) in the phenolic curing agent of component (C) is calculated from the hydroxyl equivalent. In cases where the composition of the present invention contains a plurality of kinds of phenolic curing agents as component (C), the number of hydroxyl groups is assumed to be the total number of hydroxyl groups of such curing agents.

In the present invention, the ratio of the number of functional groups of the number of epoxy groups in component (B) the epoxy compound, the number of benzoxazine rings in component (A) of the benzoxazine compound, and the number of hydroxyl groups in component (C) the phenolic curing agent in the curable resin composition preferably satisfies the following mathematical formula (2).

[Math. 2]

$$\text{(number of benzoxazine rings + number of hydroxyl groups)/number of epoxy groups} = 0.8 \text{ to } 5 \quad (2)$$

In the formula (2), the ratio of the number of functional groups is preferably 0.9 to 4, more preferably 1 to 3.5, and still more preferably 2.5 to 3. When the ratio of the number of functional groups in each of the components in the mathematical formula (2) is in the above range, a curable resin composition having more excellent low melt viscosity, and a cured product having lower mold shrinkage ratio and lower coefficient of thermal expansion, and more excellent heat resistance can be obtained.

(Component D)

The curable resin composition of the present invention may further contain, if desired, (D) a silane coupling agent. Component (D) the silane coupling agent is not particularly limited as long as the silane coupling agent does not depart from the gist of the present invention. Such a silane coupling agent is, for example, a silane coupling agent having, as a reactive group, a reactive functional group such as a vinyl group, an epoxy group, a styryl group, a methacryl group, an acryl group, an amino group, an ureido group, a mercapto group, a sulfide group, an isocyanate group, a thiocarbonyl group, a halogen group, a triazine thiol group, or a combination thereof, preferably a silane coupling agent having an amino group, more preferably a silane coupling agent having a primary amino group, a secondary amino group, or a combination thereof, more preferably a silane coupling agent having at least one primary amino group and at least one

secondary amino group in one molecule. Specifically, examples of the (D) silane coupling agent include vinyltrimethoxysilane, 2-(3,4-epoxycyclohexyl)ethyltrimethoxysilane, 3-glicydoxypropyltriethoxysilane, p-styryltrimethoxysilane, 3-methacryloxypropyltrimethoxysilane, 3-acryloxypropyltrimethoxysilane, N-2-(aminoethyl)-3-aminopropyltrimethoxysilane, 3-aminopropyltrimethoxysilane, 3-aminopropyltriethoxysilane, 3-ureidopropyltriethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, preferably, N-2-(aminoethyl)-3-aminopropyltrimethoxysilane, 3-aminopropyltrimethoxysilane. These silane coupling agents may be used singly or in a mixture of two or more kinds thereof.

The compounding ratio of component (D) is preferably in the range of 0.01 parts by mass to 10 parts by mass, more preferably in the range of 0.1 parts by mass to 5 parts by mass, in terms of the compounding ratio of component (D) with respect to 100 parts by mass of the total of components (A), (B), and (C). When component (D) is contained in such a range, it is possible to provide a curable resin composition having more excellent mechanical strength.

(Component E)

The curable resin composition of the present invention may further contain, if desired, (E) a curing accelerator. A known curing accelerator can be used as component (E) the curing accelerator, and examples thereof include, but are not limited to: amine-based compounds such as tributylamine and 1,8-diazabicyclo(5,4,0)undecene-7; imidazole-based compounds such as 2-methylimidazole, 2-ethylimidazole, and 1,2-dimethylimidazole; and organophosphorus compounds including organophosphorus compounds with phosphorus bound by only a covalent bond, such as triphenylphosphine, and salt-type organophosphorus compounds with phosphorus bound by a covalent bond and an ionic bond, such as tetraphenylphosphonium tetraphenylborate, bis(tetrabutylphosphonium) (BTBP)-pyromellitic acid, and tetra butylphosphonium 2,6-bis[(2-hydroxy-5-methylphenyl)methyl]-4-methylphenolate (TBP-3PC). The above-mentioned curing accelerators may be used singly or in combination of two or more kinds thereof. In particular, organophosphorus compounds such as triphenylphosphine, tetraphenylphosphonium tetraphenylborate, tetrabutylphosphonium 2,6-bis[(2-hydroxy-5-methylphenyl)methyl]-4-methylphenolate exert a high effect of enhancing the speed of curing and thus are preferable.

Such an organophosphorus compound described above preferably exerts a function of promoting a crosslinking reaction of an epoxy group and a phenolic hydroxyl group, as described in JP-A S55-157594. Furthermore, such an organophosphorus compound described above preferably exerts also a function of promoting a reaction of an epoxy group and a hydroxyl group generated in a cleavage reaction of (A) the benzoxazine compound at high temperatures.

The compounding ratio of component (E) is preferably in the range of 0.01 parts by mass or more and 10 parts by mass or less, more preferably in the range of 0.1 parts by mass or more and 5 parts by mass or less, in terms of the compounding ratio of component (E) with respect to 100 parts by mass of the total of components (A), (B), and (C). When component (E) is contained in such a range, it is possible to provide a curable resin composition having more excellent fast curability.

(Component F)

The curable resin composition of the present invention may further contain, if desired, (F) an inorganic filler. For example, in cases where a curable resin composition of the present invention is used for a sealant of a semiconductor element or the like, the composition preferably contains component (F). The inorganic filler for use in the present invention is not particularly limited, and can be selected in consideration of an application of the curable resin composition or a cured product thereof, or characteristics to be provided. Hereinafter, the inorganic filler is referred to as component (F).

Examples of component (F) include oxides such as silica, alumina, titanium oxide, zirconium oxide, magnesium oxide, cerium oxide, yttrium oxide, calcium oxide, antimony trioxide, zinc oxide, and iron oxide; carbonates such as calcium carbonate, magnesium carbonate, barium carbonate and strontium carbonate; sulfates such as barium sulfate, aluminum sulfate and calcium sulfate; nitrides such as aluminum nitride, silicon nitride, titanium nitride, boron nitride and manganese nitride; silicon compounds such as calcium silicate, magnesium silicate and aluminum silicate; boron compounds such as aluminum borate; zirconium compounds such as barium zirconate and calcium zirconate; phosphorus compounds such as zirconium phosphate and magnesium phosphate; titanium compounds such as strontium titanate, calcium titanate, magnesium titanate, bismuth titanate, barium titanate and potassium titanate; minerals such as mica, talc, kaolin, kaolin clay, kaolinite, halloysite, cordierite, pyrophyllite, montmorillonite, sericite, amesite, bentonite, asbestos, wollastonite, sepiolite, xonotlite, zeolite, hydrotalcite, hydrated gypsum, alum, diatomaceous earth and boehmite; fly ash, dewatered sludge, glass beads, glass fibers, silica sand, magnesium oxysulfate, silicon oxide, and silicon carbide; metals such as copper, iron, and nickel, or alloys including any of such metals; magnetic materials such as sendust, alnico magnet, ferrites; and graphite and coke. Component (F) is preferably silica or alumina. Examples of the silica include molten silica, spherical silica, crystalline silica, amorphous silica, synthetic silica, and hollow silica, preferably spherical silica such as molten spherical silica, or crystalline silica. Component (F) may be used singly or in combination

of two or more kinds thereof.

Component (F) may be particulate, and in such a case, the average particle size thereof is not particularly limited, and may be, for example, 0.01 μm or more and 150 μm or less, preferably 0.1 μm or more and 120 μm or less, more preferably 0.5 μm or more and 75 μm or less. Such a range leads to an improvement in packing ability into a mold cavity in use of the composition of the present invention in, for example, a sealant application of a semiconductor element. The average particle size of component (F) can be measured by a laser diffraction/scattering method. Specifically, the average particle size can be determined by creating the particle size distribution of the inorganic filler on a volume basis, with a laser diffraction-type particle size distribution measuring apparatus, and defining the median size as the average particle size. A measurement sample obtained by ultrasonically dispersing the inorganic filler in water can be preferably used. The laser diffraction-type particle size distribution measuring apparatus that can be used is, for example, "LA-500", "LA-750", "LA-950" or "LA-960" manufactured by HORIBA LTD.

The compounding ratio of component (F) is not limited to any particular value, and can be appropriately selected depending on its application, as long as a cured product of the curable resin composition can be obtained, the cured product having high heat resistance.

For example, in cases where the composition is used in a semiconductor-sealing application, the following compounding ratio is preferable. The lower limit value of the compounding ratio of component (F) is, for example, 80 parts by mass or more (i.e., 80% by mass or more), preferably 81 parts by mass or more, and more preferably 85 parts by mass or more with respect to 100 parts by mass of the curable resin composition. The upper limit value of the compounding ratio of component (F) is, for example, 99 parts by mass or less, preferably 95 parts by mass or less, and more preferably 90 parts by mass or less with respect to 100 parts by mass of the curable resin composition. The lower limit value of the compounding ratio of component (F) is 80 parts by mass or more, thereby enabling an increase in the amount of moisture absorption and a reduction in strength according to curing of the curable resin composition to be suppressed, and thus enabling a cured product having more favorable solder cracking resistance to be obtained. The upper limit value of the compounding ratio of component (F) is 95 parts by mass or less, thereby allowing the curable resin composition to have better fluidity and thus be easily packed into a mold, resulting in the exertion of favorable sealing performance of a cured product.

(Other component(s))

The composition of the present invention may contain a benzoxazine compound other than component (A), as long as the composition does not depart from the gist of the present invention. For example, in cases where the composition is demanded to be reduced in viscosity, a monofunctional benzoxazine compound having one benzoxazine ring may be added to the composition.

For example, nano-carbon, a flame retardant, a release agent, a colorant, a low-stress additive, a metal hydroxide, and/or the like can be compounded into the curable resin composition of the present invention, as long as the performances of the curable resin composition are not impaired.

Examples of nano-carbon include carbon nanotube, fullerene, and respective derivatives.

Examples of the flame retardant include red phosphorus; phosphates such as triphenyl phosphate, tricresyl phosphate, trixylenyl phosphate, cresyl diphenyl phosphate, xylenyl diphenyl phosphate, resorcinol bis-phenyl phosphate, bisphenol A bis-diphenyl phosphate; borates; and phosphazene.

Examples of release agents include: stearates; natural waxes such as carnauba wax; synthetic waxes such as oxidized polyethylene wax; higher fatty acids such as stearic acid or esters thereof; metal salts such as zinc stearate; paraffin; and silicone oil.

Examples of colorants include carbon black, colcothar, and titanium oxide.

Examples of low-stress additives include silicone oil and silicone rubber.

Examples of metal hydroxides include hydroxides such as calcium hydroxide, aluminum hydroxide, and magnesium hydroxide.

The compounding ratio of the other component(s) is preferably in the range of 0.01 parts by mass or more and 10 parts by mass or less, and more preferably in the range of 0.1 parts by mass or more and 7 parts by mass or less, in terms of the compounding ratio of the other component(s) with respect to 100 parts by mass in total of components (A), (B), and (C).

(Characteristics of curable resin composition)

The weight reduction ratio of the curable resin composition of the present invention during heat curing is, for example, 1.5% by mass or less, preferably 1.3% by mass or less, more preferably 1.2% by mass or less, still more preferably 1.0% by mass or less. The lower limit is not particularly limited, but is preferably 0.05% by mass or more. The weight reduction ratio can be measured with a thermogravimetric differential thermal analyzer. Such measurement can

be simply performed by use of a thermogravimetric differential thermal analyzer (for example, manufactured by HITACHI HIGH-TECH SCIENCE CORPORATION).

The viscosity of the curable resin composition of the present invention at 100°C is, for example, 2.0 Pa·s or less, preferably 1.9 Pa·s or less, more preferably 1.8 Pa·s or less, and still more preferably 1.4 Pa·s or less (also referred to as low melt viscosity), from the viewpoint of fluidity and handling of the curable resin composition. The lower limit is not particularly limited, but is preferably 0.1 Pa·s or more. By measuring the viscosity of the curable resin composition without containing the inorganic filler and/or curing accelerator, it is possible to predict the amount of the inorganic filler in such a range that will not deteriorate the fluidity in the curable resin composition containing the inorganic filler. The viscosity can be measured with a cone-plate viscometer. Such measurement can be simply performed by use of a commercially available cone-plate viscometer (for example, manufactured by Brookfield Corporation).

[Method of producing curable resin composition]

Next, a method of producing the curable resin composition of the present invention will be described.

A curable resin composition of the present invention can be produced by kneading or mixing components (A) to (C), and further, if desired, adding components (D), (E), (F), the other component(s), and a solvent.

The kneading or mixing method is not particularly limited, and the mixing can be made using, for example, a mixing apparatus or a kneading machine such as a planetary mixer, a twin-screw extruder, a heat roll, or a kneader. For example, in cases where components (A), (B), and (C) are highly viscous liquids or solids at room temperature or in cases where component (F) is contained, the components may be kneaded under heating, if necessary, and may be further kneaded under pressure or under reduced pressure. The heating temperature is preferably 80 to 120°C. The curable resin composition which contains component (F) is a solid at room temperature, and thus may be heated and kneaded, and thereafter cooled and pulverized to provide a powder, or the powder may be tableted and thus formed into pellets. The powder may also be granulated into granule form.

In cases where the curable resin composition of the present invention does not contain component (F), and is used in an application of prepregs for FRP, the curable resin composition preferably has a viscosity of 10 to 3000 Pa·s at 50°C. The viscosity is more preferably 10 to 2500 Pa·s, and still more preferably 100 to 2000 Pa·s. In cases where the curable resin composition of the present invention is used in a sealant or coating application, the viscosity is not limited, as long as working such as sealing or coating is not impaired.

[Cured product]

The cured product of the curable resin composition of the present invention is characterized by having a high glass transition temperature and having excellent heat resistance. The reason why such an excellent cured product is formed by the curable resin composition of the present invention is considered as follows.

In the homopolymerization of benzoxazine, a phenolic hydroxyl group is first produced by polymerization. It is considered that this phenolic hydroxyl group undergoes keto-enol tautomerization at a high temperature, for example, 200°C or higher, thereby resulting in cleavage of polymer chains, and thus causing lower heat resistance as well as lower glass transition temperature.

In contrast, it is considered that, in the curable resin composition of the present invention, since the number of benzoxazine rings in the (A) benzoxazine compound, the number of epoxy groups in the (B) epoxy compound, and the number of hydroxyl groups in the (C) phenolic curing agent satisfy the mathematical formula (1), the phenolic hydroxyl groups generated by homopolymerization of the benzoxazine is rapidly reacted with the epoxy compound to form a densely crosslinked structure, which makes the curable resin composition excellent in heat resistance.

(Characteristics of cured product)

The heat resistance of a cured product of the present invention can be evaluated by measuring the glass transition temperature. The glass transition temperature is, for example, 185°C or higher, preferably 190°C or higher, and more preferably 200°C or higher. The upper limit is not particularly limited, but is preferably 400°C or lower. The glass transition temperature can be measured by differential scanning calorimetry (DSC). Such measurement can be simply performed by use of a commercially available differential scanning calorimeter (for example, manufactured by HITACHI HIGH-TECH SCIENCE CORPORATION).

The coefficient of thermal expansion of the cured product of the present invention is, for example, 13.5 ppm/°C or less, preferably 13.0 ppm/°C or less, and more preferably 12.5 ppm/°C or less. The lower limit is not particularly limited, but is preferably 0.1 ppm/°C or more. The coefficient of thermal expansion can be measured according to JIS K7197, the testing method for linear thermal expansion coefficient of plastics by thermomechanical analysis. Such measurement can be simply performed by use of a commercially available thermo mechanical analyzer (for example,

manufactured by HITACHI HIGH-TECH SCIENCE CORPORATION; a tradename, TMA7100) according to JIS K7197, the testing method for linear thermal expansion coefficient of plastics by thermomechanical analysis.

The mold shrinkage ratio of the cured product of the present invention is, for example, 0.50% or less, preferably 0.45% or less. The lower limit is not particularly limited, but is preferably 0.01% or more. After molding, the cured product is allowed to stand still in a thermostatic chamber (temperature, 23°C; humidity, 50%) overnight, then measured for its dimension in the length direction with a caliper, and the mold shrinkage ratio can be calculated according to the following calculation formula:

$$\text{Mold shrinkage ratio [\%]} = \text{(dimension of mold} - \text{dimension of test piece)/dimension of mold} \times 100$$

[Method of producing cured product]

A cured product of the present invention can be produced by performing ring-opening polymerization for curing, under the same curing conditions as those for known benzoxazine compounds and/or epoxy compounds. Examples include the following methods.

First, a curable resin composition of the present invention is produced by the above-mentioned method. Subsequently, the resulting curable resin composition can be heated at, for example, 150 to 300°C for a curing time of, for example, 20 seconds to 5 hours, preferably 20 seconds to 1 hour, to obtain a cured product. While a curing time of 1 to 3 minutes is sufficient for continuous production of the cured product, it is preferable to further heat for approximately 5 minutes to 6 hours in post-curing for achieving a higher strength.

A benzoxazine compound other than component (A) and/or an epoxy compound other than component (B) can be compounded to obtain a cured product as long as the compounds do not depart from the gist of the present invention.

In the cases where a film-shaped molded product is obtained as the cured product, a solvent can further be compounded to provide a composition which has a suitable solution viscosity for film formation. The solvent is not particularly limited as long as components (A) to (E) can be dissolved therein, and examples thereof include hydrocarbons, ethers, esters, and halogen-containing solvents.

In the case of such a solution-type curable resin composition dissolved in the solvent, the cured product can be obtained by coating a substrate with the solution-type curable resin composition, thereafter volatilizing the solvent, and then performing thermal curing.

[Semiconductor device]

The semiconductor device of the present invention is a semiconductor device where a semiconductor element is disposed in a cured product obtained by curing the curable resin composition of the present invention, the composition containing components (A) to (C), and, if desired, (D), (E), (F), and/or the other component(s). The semiconductor element is here usually supported and secured by a lead frame being a thin plate of a metallic material. The phrase "semiconductor element is disposed in a cured product" means that the semiconductor element is sealed by a cured product of the curable resin composition, and represents the state where the semiconductor element is covered with the cured product. In such a case, the entire semiconductor element may be covered, or the surface of the semiconductor element disposed on a base plate may be covered.

In cases where the semiconductor device is produced by sealing any of various electronic components, such as a semiconductor element, with the cured product of the present invention, the semiconductor device can be produced by performing a sealing step according to a conventional molding method, such as transfer molding, compression molding or injection molding.

## EXAMPLES

Hereinafter, the present invention will be specifically described with reference to Examples and Comparative Examples; however, the present invention is not intended to be limited to such Examples.

<Component (A): multifunctional benzoxazine compound>

The following (A1) and (A2) were used as component (A).

(A1): Phenol-diaminodiphenylmethane (P-d)-type benzoxazine represented by the following formula (manufactured by SHIKOKU CHEMICALS CORPORATION) (benzoxazine equivalent (g/eq): 217).

[Chem. 21]

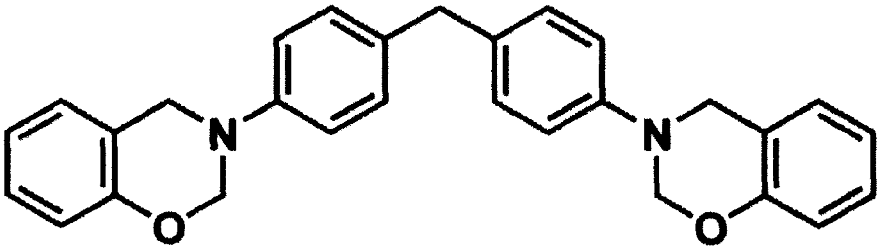

(A2): Benzoxazine (3-[3-[4-(2H-1,3-benzoxazine -3(4H)-yl)phenoxy]phenyl]-3,4-dihydro-2H-1,3-benzoxazine)(3,4'-APE-BOZ)(benzoxazine equivalent (g/eq):218, HONSHU CHEMICAL INDUSTRY CO., LTD., a development article) represented by the following formula (1-1-1).

[Chem. 22]

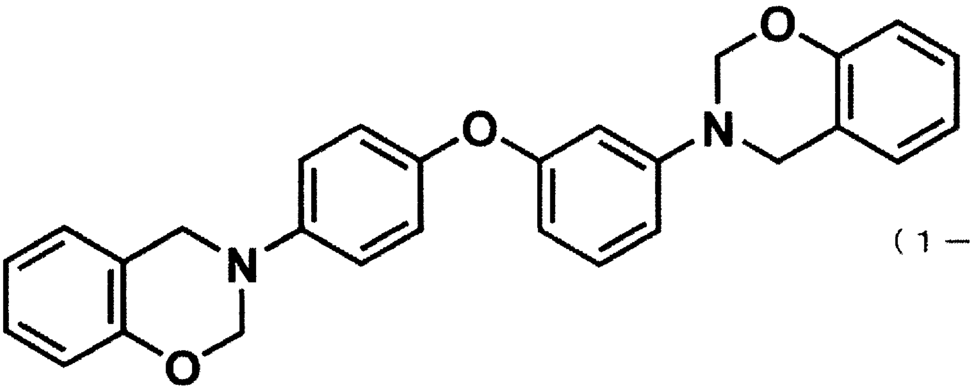

(1-1-1)

<Component (B): epoxy compound>

The following (B1) to (B5) were used as component (B).

(B1) Epoxy compound 1: compound of formula (5-1)

Compound (a) represented in the formula (6) was synthesized according to a method described in "Shoichi Tsuchida et al., "Diels-Alder Reaction between Butadiene and Cyclopentadiene-Determination of Trimers-", Journal of the Japan Petroleum Institute, 1972, Vol. 15, Issue 3, pages 189 to 192".

Next, the reaction of the formula (6) was performed as follows. A reaction vessel was charged with 23.5 kg of chloroform and 1.6 kg of the compound (a), and 4.5 kg of meta-chloroperbenzoic acid was added dropwise thereto with stirring at 0°C. The temperature was raised to room temperature, and the reaction was performed for 12 hours.

Next, meta-chlorobenzoic acid as a by-product was removed by filtration, and thereafter, the filtrate was washed with an aqueous 1 N sodium hydroxide solution three times, and then washed with saturated saline. After the organic layer was dried over magnesium sulfate, the magnesium sulfate was removed by filtration, and the filtrate was concentrated, to obtain a crude product.

To the crude product was added 2 kg of toluene, to dissolve the crude product at room temperature. Thereto was added dropwise 6 kg of heptane for crystallization, and the resultant was aged at 5°C for 1 hour. The resultant crystallized product was collected by filtration and washed with hexane. The product was dried under reduced pressure at 35°C for 24 hours, to obtain 1.4 kg of a compound represented by the following formula (5-1), as a white solid.

[Chem. 23]

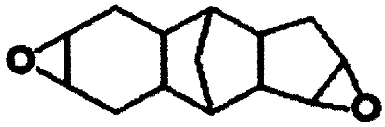

(5-1)

(B2) Epoxy compound 2: compound (tricyclopentadiene diepoxide) of formula (5-2)

The compound (b) represented in formula (7) was synthesized according to a method described in "Shoichi Tsuchida et al., "Diels-Alder Reaction between Butadiene and Cyclopentadiene-Determination of Trimers-", Journal of the Japan Petroleum Institute, 1972, Vol. 15, Issue 3, pages 189 to 192".

Next, the reaction of formula (7) was performed as follows. A reaction vessel was charged with 59.2 kg of chloroform and 4.0 kg of the compound (b), and 10.6 kg of meta-chloroperbenzoic acid was added dropwise thereto with stirring at -10°C. The temperature was raised to room temperature, and the reaction was performed for 12 hours.

Next, meta-chlorobenzoic acid as a by-product was removed by filtration, and thereafter, the filtrate was washed with 42.0 kg of an aqueous 5% sodium sulfite solution. The organic layer was further washed with 41.6 kg of an aqueous 1 N sodium hydroxide solution four times, and then washed with 48.0 kg of saturated saline. After the organic layer was dried over magnesium sulfate, the magnesium sulfate was removed by filtration, and the filtrate was concentrated, to obtain 5.1 kg of a crude product.

To the crude product was added 3.5 kg of toluene, to dissolve the crude product at room temperature. Thereto was added dropwise 13.7 kg of heptane for crystallization, and the resultant was aged at 5°C for 1 hour. The resultant crystallized product was collected by filtration and washed with heptane. The product was dried under reduced pressure at 35°C for 12 hours, to obtain 2.8 kg of a compound represented by the following formula (5-2), as a white solid.

[Chem. 24]

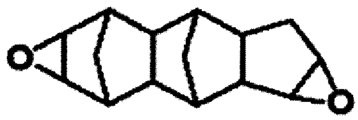

(5-2)

(B3) Epoxy compound 3: epoxy compound (EPPN-501H, epoxy equivalent (g/eq):162 to 172, manufactured by NIPPON KAYAKU CO., LTD.) represented by the following formula (9-1).

[Chem. 25]

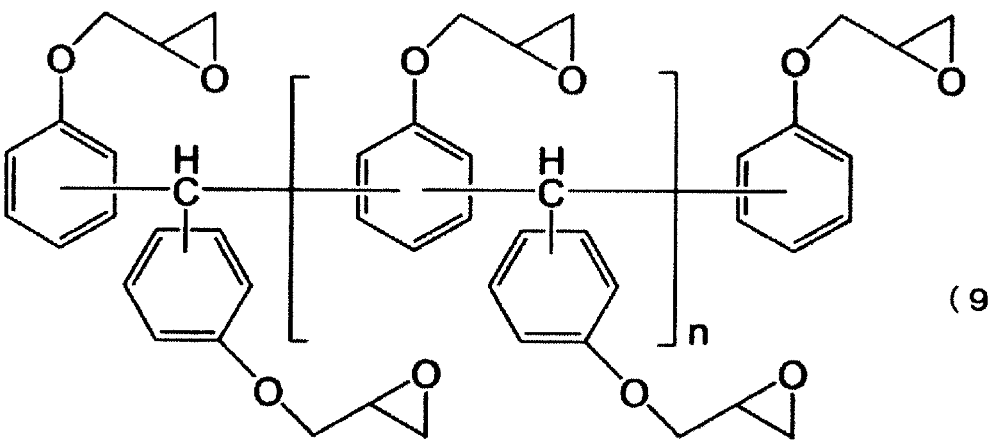

(9-1)

wherein in the formula (9-1), n is an average value and is 1.3.

(B4) Epoxy compound 4: epoxy compound (EPPN-502H, epoxy equivalent (g/eq):158 to 178, manufactured

by NIPPON KAYAKU CO., LTD.) represented by the following formula (9-2).

[Chem. 26]

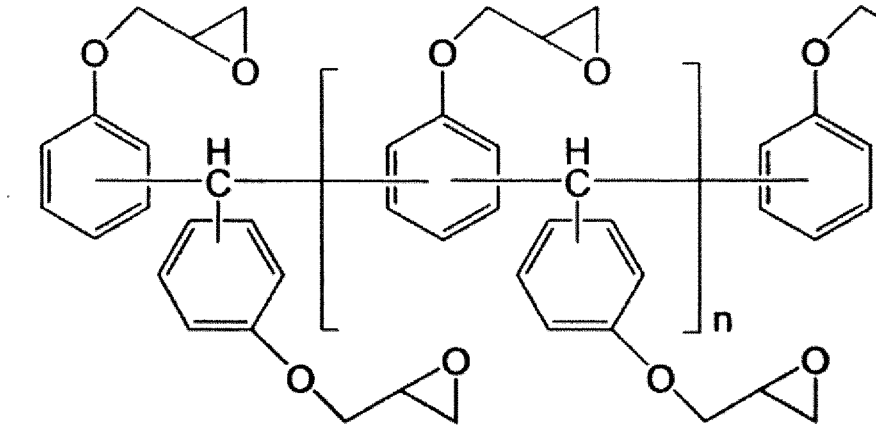

(9-2)

wherein in the formula (9-2), n represents an average value and is 1.8.

(B5) Epoxy compound 5: naphthol type epoxy compound (NC-7300L, epoxy equivalent (g/eq): 207 to 221, manufactured by NIPPON KAYAKU CO., LTD.)

<Component (C): phenolic curing agent>

The following (C1) and (C2) were used as component (C).

(C1) Phenolic curing agent 1: bisphenol F (bisphenol F, hydroxyl equivalent 100.115, manufactured by HONSHU CHEMICAL INDUSTRY CO., LTD).

(C2) Phenolic curing agent 2: phenol novolac resin (TD-2131, hydroxyl equivalent 104, manufactured by DIC CORPORATION).

<Component (D): silane coupling agent>

The following (D1) and (D2) were used as component (D).

(D1) Silane coupling agent 1: N-2-(aminoethyl)-3-aminopropyl trimethoxysilane (KBM-603, manufactured by Shin-Etsu Silicones)

(D2) Silane coupling agent 2: 3-aminopropyl trimethoxysilane (KBM-903, manufactured by Shin-Etsu Silicones)

<Component (E): curing accelerator>

Tetrabutyl phosphonium 2,6-bis[(2-hydroxy-5-methylphenyl)methyl]-4-methylphenolate (TBP-3PC, manufactured by HOKKO CHEMICAL INDUSTRY CO., LTD.) was used as component (E).

<Component (F): inorganic filler>

Molten spherical silica (FB-820, manufactured by DENKA COMPANY LIMITED) having an average particle size D50 of 22 μm was used as component (F).

<Other components>

Carnauba wax (WE-4, manufactured by CLARIANT CHEMICALS LTD.) as a release agent and carbon black (MA600, manufactured by MITSUBISHI CHEMICAL CORPORATION) as a colorant were used.

(Example 1)

A curable resin composition (hereinafter simply referred to as a "composition") and a cured product were prepared as below-mentioned to measure the weight reduction ratio, the mold shrinkage ratio, the glass transition

temperature, the coefficient of thermal expansion, and the viscosity.

After components of (A) the benzoxazine compound, (B) the epoxy compound, (C) the phenolic curing agent, (D) the silane coupling agent, (E) the curing accelerator, (F) the inorganic filler, the release agent (carnauba wax), and carbon black were kneaded at a compounding ratio shown in Table 1, by use of a heat roll kneader including the respective two rolls having surface temperatures of 90°C and 100°C (Type, "BR-150HCV", from AIMEX CO., Ltd.), under atmospheric pressure for 10 minutes, the resultant was cooled to room temperature to obtain a mixture. The resulting mixture was pulverized into powdery form using Mini Speed Mill (Type, "MS-09", manufactured by LABONECT CO., LTD.) so that packing into a mold was favorably performed, thereby obtaining a composition.

<Weight reduction ratio>

About 10 mg of the resulting powdery composition was weighed into an aluminum sample pan, and heated from 40°C to 175°C under a condition at a rate of temperature rise of 10 °C/min using a thermogravimetric differential thermal analyzer (Type "STA7200RV", manufactured by HITACHI HIGH-TECH SCIENCE CORPORATION), held for 1 hour after reaching 175°C, and the weight reduction ratio was measured. The results are shown in Table 1.

<Mold shrinkage ratio>

The composition prepared above was cured using a transfer molding machine (Type "ADM-5", manufactured by MEIHO CO., LTD.) under conditions at a mold temperature of 175°C at an injection pressure of 4 MPa for a curing time of 3 minutes to a test piece, 3 mm in vertical × 10 mm in horizontal × 70 mm in length. After molding, the test piece was allowed to stand still in a thermostatic chamber (temperature, 23°C; humidity, 50%) overnight, then measured for its dimension in the length direction with a caliper, and the mold shrinkage ratio was calculated according to the following calculation formula:

$$\text{Mold shrinkage ratio [\%]} = (\text{dimension of mold} - \text{dimension of test piece})/\text{dimension of mold} \times 100$$

<Glass transition temperature: Tg>

The test piece obtained by transfer molding was further heated in an oven at 175°C for 5 hours to obtain a cured product as a post-treatment. The resulting cured product was cut to provide a test piece having a size of 3 mm in vertical × 2 mm in horizontal × 2 mm in length, and the resulting test piece was measured for the glass transition temperature using a differential scanning calorimetric analyzer (Type, "X-DSC-7000"; rate of temperature rise, 20 °C/min, manufactured by HITACHI HIGH-TECH SCIENCE CORPORATION). The results are shown in Table 1.

<Coefficient of thermal expansion (CTE)>

The test piece obtained by transfer molding was further heated in an oven at 175°C for 5 hours to obtain a cured product as a post-treatment. The cured product was cut to provide a test piece having a size of 3 mm in vertical × 5 mm in horizontal × 10 mm in length. The resulting test piece was heated from 25 to 150°C under a compressive load of 20 mN at a rate of temperature rise of 5 °C/min according to JIS K7197: the testing method for linear thermal expansion coefficient of plastics by thermomechanical analysis, using a thermomechanical analyzer (Type, "TMA7100", manufactured by HITACHI HIGH-TECH SCIENCE CORPORATION), and the coefficient of thermal expansion was determined from the inclination of the SS curve in that event. The results are shown in Table 1.

<Viscosity>

Components (A) of the benzoxazine compound, (B) the epoxy compound, and (C) the phenolic curing agent were weighed at the ratio shown in Table 1 in a φ50 mm aluminum pan and melt mixed on a hot plate heated to 110°C for 5 minutes to obtain a compound. The viscosity of the compound at 100°C was measured using a cone-plate viscosimeter (Type "CAP2000+H"; cone angle, 3°; rotational speed, 100 rpm; manufactured by Brookfield Engineering Laboratories, Inc.). The results are shown in Table 1.

(Example 2 to 9)

Each composition of Examples was prepared in the same manner as in Example 1 except that the compounding ratio of each of the components was as shown in Table 1. Each of the compositions and cured products thereof was measured for the weight reduction ratio, the mold shrinkage ratio, the glass transition temperature, the coefficient of thermal expansion, and the viscosity in the same manner as in Example 1. The results are shown in Table 1.

(Comparative Examples 1 to 5)

Each composition of Comparative Examples was prepared in the same manner as in Example 1 except that the compounding ratio of each of the components was as shown in Table 1. Each of the compositions and cured products thereof was measured for the weight reduction ratio, the mold shrinkage ratio, the glass transition temperature, the coefficient of thermal expansion, and the viscosity in the same manner as in Example 1. The results are shown in Table 1.

[Table 1]

| | | | Example | | | | | | | | | Comparative Example | | | | |
|---|---|---|---|---|---|---|---|---|---|---|---|---|---|---|---|---|
| | | | 1 | 2 | 3 | 4 | 5 | 6 | 7 | 8 | 9 | 1 | 2 | 3 | 4 | 5 |
| Component (% by mass) | Benzoxazine compound | (A1) | 9.43 | 11.29 | 10.53 | 11.29 | 11.65 | 11.09 | | 9.53 | 8.15 | 6.86 | 7.46 | 13.53 | 6.88 | 8.73 |
| | | (A2) | | | | | | | 9.72 | | | | | | | |
| | Epoxy compound | (B1) | 0.68 | 1.49 | 1.38 | 1.49 | 1.05 | 0.88 | 1.59 | 1.68 | 1.98 | 2.99 | 2.81 | 0.11 | 0.93 | 2.30 |
| | | (B2) | 1.37 | | | | | | | | | | | 0.23 | 3.74 | |
| | | (B3) | | 3.47 | | 3.47 | | 4.30 | 3.71 | 1.01 | 5.95 | | 6.56 | | | 5.37 |
| | | (B4) | 4.79 | | 2.08 | | 1.05 | | | | | 2.99 | | 1.37 | 4.67 | |
| | | (B5) | | | 2.08 | | 2.10 | | | 4.04 | | | | | | |
| | Phenolic curing agent | (C1) | 1.89 | 1.69 | 2.11 | 1.69 | 2.33 | 1.66 | 2.92 | 1.67 | 1.63 | 1.37 | 1.12 | 2.71 | | 1.31 |
| | | (C2) | | | | | | | | | | | | | 1.72 | |
| | Silane coupling agent | (D1) | 0.20 | 0.20 | 0.20 | | 0.20 | 0.20 | 0.20 | 0.20 | 0.20 | 0.20 | 0.20 | 0.20 | 0.20 | 0.20 |
| | | (D2) | | | | 0.20 | | | | | | | | | | |
| | Curing accelerator | (E) | 0.23 | 0.46 | 0.23 | 0.46 | 0.23 | 0.46 | 0.46 | 0.46 | 0.69 | 0.18 | 0.46 | 0.46 | 0.46 | 0.69 |
| | Release agent | | 0.2 | 0.2 | 0.2 | 0.2 | 0.2 | 0.2 | 0.2 | 0.2 | 0.2 | 0.2 | 0.2 | 0.2 | 0.2 | 0.2 |
| | Colorant | | 0.2 | 0.2 | 0.2 | 0.2 | 0.2 | 0.2 | 0.2 | 0.2 | 0.2 | 0.2 | 0.2 | 0.2 | 0.2 | 0.2 |
| | Inorganic filler (F) | | 81.00 | 81.00 | 81.00 | 81.00 | 81.00 | 81.00 | 81.00 | 81.00 | 81.00 | 85.00 | 81.00 | 81.00 | 81.00 | 81.00 |
| Filling rate of inorganic filler [% by mass] | | | 81 | 81 | 81 | 81 | 81 | 81 | 81 | 81 | 81 | 85 | 81 | 81 | 81 | 81 |
| (number of benzoxazine rings + number of hydroxyl groups)/number of epoxy groups | | | 1.33 | 2.0 | 2.0 | 2.0 | 3.0 | 2.0 | 2.0 | 1.5 | 1.0 | 1.0 | 0.7 | 8.0 | 0.7 | 1.0 |
| Content of alicyclic epoxy compound [% by mass] | | | 11.3 | 8.3 | 7.6 | 8.3 | 5.8 | 4.9 | 8.9 | 9.4 | 11.2 | 21.1 | 15.7 | 1.9 | 26.0 | 13.0 |

(continued)

| | | Example | | | | | | | | | Comparative Example | | | | |
|---|---|---|---|---|---|---|---|---|---|---|---|---|---|---|---|
| | | 1 | 2 | 3 | 4 | 5 | 6 | 7 | 8 | 9 | 1 | 2 | 3 | 4 | 5 |
| Performance evaluation | Weight reduction ratio [% by mass] | 0.75 | 0.46 | 0.63 | 0.82 | 0.32 | 0.45 | 0.32 | 0.48 | 0.66 | 1.65 | 1.11 | 0.17 | 1.64 | 1.66 |
| | Tg [°C] | 200 | 203 | 200 | 206 | 191 | 209 | 211 | 192 | 187 | 204 | 147 | 179 | 180 | 183 |
| | Viscosity [Pa·sec] | 1.1 | 1.2 | 1.1 | 1.3 | 1.1 | 1.3 | 1.0 | 0.9 | 0.9 | 0.8 | 0.6 | 2.6 | 2.2 | 0.8 |
| | CTE [ppm/°C] | 12.1 | 10.2 | 10.6 | 9.1 | 10.4 | 11.0 | 10.1 | 10.8 | 13.2 | 8.7 | 14.3 | 10.4 | 14.0 | 13.2 |
| | Mold shrinkage ratio [%] | 0.42 | 0.34 | 0.41 | 0.39 | 0.23 | 0.39 | 0.39 | 0.38 | 0.40 | 0.27 | 0.62 | 0.23 | 0.59 | 0.53 |

Since the weight reduction ratio of each curable resin composition of Examples during heat curing is 1.0% by mass or less, the weight reduction ratio of the composition is low. Since the viscosity of each curable resin composition of Examples is 2.0 Pa·s or less, the viscosity of the composition is low. The cured product of the curable resin composition has a Tg of 185°C or higher, and it is found that the products exhibit high heat resistance. Moreover, since the coefficient of thermal expansion of the cured product is 13.5 ppm/°C or less, the coefficient of thermal expansion of the composition is low. Since the mold shrinkage ratio of the cured product is 0.45% or less, the mold shrinkage ratio of the composition is low. On the other hand, the weight reduction ratio of the curable resin composition of Comparative Example 1 during heat curing is higher. In addition, the weight reduction ratio of the curable resin composition of Comparative Example 2 during heat curing is high, and, since the cured product has low Tg, it has poor heat resistance, and higher coefficient of thermal expansion and mold shrinkage ratio. The cured product obtained by curing the curable resin composition of Comparative Examples 3 also has a lower Tg and the curable resin composition has higher viscosity. The weight reduction ratio of the curable resin composition of Comparative Example 4 during heat curing is higher, and the coefficient of thermal expansion and mold shrinkage ratio of the cured product thereof is higher, Tg of the cured product is lower, and the viscosity of the curable resin composition is higher. The weight reduction ratio of the curable resin composition of Comparative Example 5 during heat curing is higher, the mold shrinkage ratio of the cured product thereof is higher, and Tg of the cured product is lower.

The above-mentioned results have revealed that a curable resin composition according to an embodiment of the present invention has low weight reduction ratio during heat curing and low melt viscosity, and a cured product thereof has high heat resistance, low mold shrinkage ratio, and low coefficient of thermal expansion.

## Claims

1. A curable resin composition, comprising:

   (A) a benzoxazine compound;
   (B) an epoxy compound; and
   (C) a phenolic curing agent, wherein
   the number of benzoxazine rings in the (A) benzoxazine compound, the number of epoxy groups in the (B) epoxy compound, and the number of hydroxyl groups in the (C) phenolic curing agent satisfy the following mathematical formula (1),
   the (B) epoxy compound comprises an alicyclic epoxy compound, and
   the content of the (B) alicyclic epoxy compound is 3 to 12% by mass with respect to the total of the (A) benzoxazine compound, the (B) epoxy compound, and the (C) phenolic curing agent:
   [Math. 1]

$$\text{(number of benzoxazine rings + number of hydroxyl groups)/number of epoxy groups} = 0.8 \text{ to } 5 \quad (1)$$

2. The curable resin composition according to claim 1, wherein the (A) benzoxazine compound is a multifunctional benzoxazine compound having at least two benzoxazine rings, the compound being at least one multifunctional benzoxazine compound selected from a multifunctional benzoxazine compound having a structural unit of formula (1) and a multifunctional benzoxazine compound represented by a structure of formula (2);

[Chem. 1]

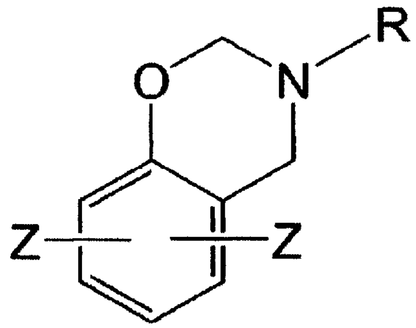

(1)

wherein in the formula (1), R represents a linear alkyl group having 1 to 12 carbon atoms, a cyclic alkyl group having 3 to 8 carbon atoms, or an aryl group having 6 to 14 carbon atoms, wherein the aryl group optionally has halogen or a linear alkyl group having 1 to 12 carbon atoms, as a substituent; and each Z represents hydrogen, a hydrocarbon group having 1 to 8 carbon atoms and/or a linking group and is optionally the same or different; at least one Z represents a linking group, and the benzoxazine rings are linked by the linking group;

[Chem. 2]

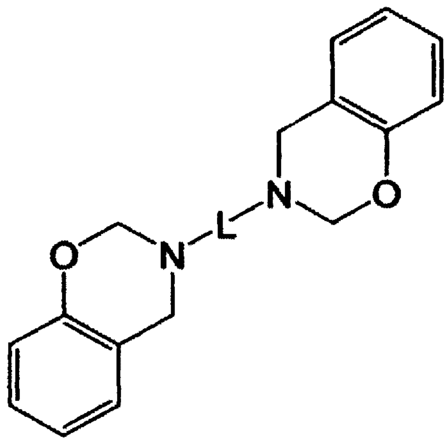

(2)

wherein in the formula (2), L represents a divalent organic group having 1 to 5 aromatic rings or an alkylene group having 2 to 10 carbon atoms, and the organic group and the alkylene group optionally contain oxygen and/or sulfur.

**3.** The curable resin composition according to claim 1 or 2, wherein the alicyclic epoxy compound is an epoxy compound having at least one norbornane structure and at least two epoxy groups.

**4.** The curable resin composition according to any one of claims 1 to 3, wherein the alicyclic epoxy compound has at least one structure selected from the group consisting of a 5-membered ring structure, 6-membered ring structure, and a norbornane ring structure represented by the formula (3);

[Chem. 3]

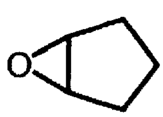
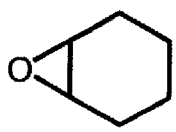
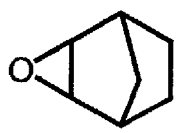

(3)

**5.** The curable resin composition according to any one of claims 1 to 4, wherein the alicyclic epoxy compound has no

glycidyl group.

6. The curable resin composition according to any one of claims 1 to 5, further comprising (D) a silane coupling agent.

7. The curable resin composition according to claim 6, wherein the (D) silane coupling agent contains at least one primary amino group and at least one secondary amino group in a single molecule.

8. The curable resin composition according to any one of claims 1 to 7, further comprising (E) a curing accelerator.

9. The curable resin composition according to any one of claims 1 to 8, further comprising (F) an inorganic filler.

10. The curable resin composition according to claim 9, wherein the content of the (F) inorganic filler is 80 to 95% by mass with respect to the total of the curable resin composition.

11. A cured product obtained by curing the curable resin composition according to any one of claims 1 to 10.

12. A semiconductor device, wherein a semiconductor element is disposed in a cured product obtained by curing the curable resin composition according to any one of claims 1 to 10.

13. A method of producing the curable resin composition according to any one of claims 1 to 10, the method comprising the steps of:

mixing

(A) a benzoxazine compound,
(B) an epoxy compound, and
(C) a phenolic curing agent

to obtain a mixture; and
processing the mixture into a powdery, pelletized, or granular curable resin composition.

14. The production method according to claim 13, wherein the step of obtaining the mixture includes further mixing at least one component selected from the group consisting of (D) a silane coupling agent, (E) a curing accelerator, and (F) an inorganic filler.

15. A method of producing a cured product, including a step of heating the curable resin composition produced by the method according to claim 13 or 14, at 150 to 300°C for 20 seconds to 6 hours for curing.

## INTERNATIONAL SEARCH REPORT

International application No.
**PCT/JP2022/003719**

### A. CLASSIFICATION OF SUBJECT MATTER

***C08G 59/40***(2006.01)i; ***C08K 5/5415***(2006.01)i; ***C08L 63/00***(2006.01)i; ***C08K 3/013***(2018.01)i
FI: C08G59/40; C08L63/00 B; C08K5/5415; C08K3/013

According to International Patent Classification (IPC) or to both national classification and IPC

### B. FIELDS SEARCHED

Minimum documentation searched (classification system followed by classification symbols)

C08G59/00-59/72; C08K3/00-13/08; C08L63/00-63/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br><br><br>Y | WO 2017/188448 A1 (JXTG NIPPON OIL & ENERGY CORP) 02 November 2017 (2017-11-02)<br>claims, paragraphs [0007], [0008], [0049], examples, "tables 1, 2" | 1-5, 11<br><br><br>6-10, 12-15 |
| Y | WO 2020/218457 A1 (JXTG NIPPON OIL & ENERGY CORP) 29 October 2020 (2020-10-29)<br>claims, paragraphs [0057], [0065], [0069] | 6-10, 12-15 |
| Y | JP 2019-19217 A (JXTG NIPPON OIL & ENERGY CORP) 07 February 2019 (2019-02-07)<br>claims, paragraph [0047] | 6-10, 12-15 |
| Y | WO 2019/073763 A1 (AJINOMOTO KK) 18 April 2019 (2019-04-18)<br>claims, paragraphs [0065], [0115] | 7 |
| A | JP 2019-515115 A (HUNTSMAN ADVANCED MATERIALS AMERICAS LLC) 06 June 2019 (2019-06-06)<br>claims 11-14 | 1-15 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 March 2022** | **19 April 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/003719**

**C. DOCUMENTS CONSIDERED TO BE RELEVANT**

| Category* | Citation of document, with indication, where appropriate, of the relevant passages | Relevant to claim No. |
|---|---|---|
| A | CN 106995582 A (HENGSHEN CO., LTD.) 01 August 2017 (2017-08-01) claims, examples | 1-15 |
| P, A | WO 2021/192822 A1 (KYOCERA CORP) 30 September 2021 (2021-09-30) claims, examples | 1-15 |

Form PCT/ISA/210 (second sheet) (January 2015)

**INTERNATIONAL SEARCH REPORT**
**Information on patent family members**

International application No.
**PCT/JP2022/003719**

| Patent document cited in search report | Publication date (day/month/year) | Patent family member(s) | Publication date (day/month/year) |
|---|---|---|---|
| WO 2017/188448 A1 | 02 November 2017 | US 2019/0119447 A1<br>claims, paragraphs [0008], [0009], [0036], examples, "tables 1, 2<br>CN 109071918 A<br>KR 10-2019-0003590 A | |
| WO 2020/218457 A1 | 29 October 2020 | TW 202100707 A | |
| JP 2019-19217 A | 07 February 2019 | (Family: none) | |
| WO 2019/073763 A1 | 18 April 2019 | US 2020/0231786 A1<br>claims, paragraphs [0184], [0243]<br>CN 111164151 A<br>KR 10-2020-0063157 A | |
| JP 2019-515115 A | 06 June 2019 | US 2019/0225752 A1<br>claims 11-14<br>WO 2017/196805 A1<br>CN 109563287 A | |
| CN 106995582 A | 01 August 2017 | (Family: none) | |
| WO 2021/192822 A1 | 30 September 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2021015288 A
- JP 2013008800 A
- WO 2007037500 A
- JP 2018184533 A
- JP S55157594 A


### Non-patent literature cited in the description


- **SHOICHI TSUCHIDA et al.** Diels-Alder Reaction between Butadiene and Cyclopentadiene-Determination of Trimers. *Journal of the Japan Petroleum Institute,* 1972, vol. 15 (3), 189-192